# EUROPÄISCHE PATENTSCHRIFT

(11) **EP 2 921 930 B1**
(45) Veröffentlichungstag und Bekanntmachung des Hinweises auf die Patenterteilung: **13.02.2019**
(21) Anmeldenummer: 15157606.3
(22) Anmeldetag: 04.03.2015
(51) Int. Cl.: G06F 1/16, H04M 1/02, H04M 1/18

(54) **SCHUTZGEHÄUSE FÜR EIN ELEKTRONISCHES GERÄT**
PROTECTIVE CASE FOR AN ELECTRONIC DEVICE
ÉTUI DE PROTECTION POUR UN DISPOSITIF ÉLECTRONIQUE

(30) Priorität: 19.03.2014 DE 102014205137
(43) Veröffentlichungstag der Anmeldung: 23.09.2015
(73) Patentinhaber: ecom instruments GmbH, 97959 Assamstadt (DE)
(72) Erfinder: Hofmann, Dieter, 97922 Lauda-Königshofen (DE); Rössler, Dieter, 74670 Forchtenberg-Ernsbach (DE)
(74) Vertreter: BRP Renaud & Partner mbB Rechtsanwälte Patentanwälte Steuerberater

(56) Entgegenhaltungen:
- WO-A1-2013/106474
- WO-A1-2013/181644
- US-A1- 2009 080 153
- US-B1- 8 503 170

## Beschreibung

Die Erfindung betrifft eine Geräte-Anordnung.

Moderne Computer werden in zunehmendem Maße in Form sogenannter Tablet-Computer - in Fachkreisen auch vereinfacht "Tablets" genannt - hergestellt. Bei einem solchen Tablet handelt es sich um einen tragbaren Computer mit flacher Geometrie, der über ein in Form eines Touchscreens ausgebildetes, berührungsempfindliches Display verfügt, d.h. das Display des Tablet-Computers dient gleichzeitig als Eingabeeinheit, wodurch die Bereitstellung einer Tastatur oder einer Maus entbehrlich wird. Tablets der neuesten Generation ähneln in ihrem Leistungsumfang jenem moderner Smartphones.

Aufgrund ihrer einfachen Handhabung finden Tablet-Computer auch in zunehmendem Maße in explosionsgefährdeten Bereichen wie beispielsweise Öl-Bohrplattformen o.ä. als Arbeitsgerät Anwendung. Für jedwede Gehäuse, in denen elektronische Geräte montiert werden, die in solchen, explosionsgefährdeten Bereichen zum Einsatz kommen sollen, gelten u.a. in der DIN-Norm EN 60079-0 definierte Anforderungen an deren mechanische Festigkeit. Auf diese Weise soll verhindert werden, dass das Gehäuse durch von außen wirkende mechanische Stöße, zerstört und das im Gehäuse aufgenommene Gerät freigelegt und mit der Umgebung in Kontakt geraten kann.

WO2013106474 und US8503170 offenbaren bekannte Schutzhüllen für Tablet-Computer.

Es ist daher eine Aufgabe der vorliegenden Erfindung, eine verbesserte Ausführungsform einer Geräte-Anordnung mit einem elektronischen Gerät, insbesondere einem Tablet-Computer, zu schaffen, welche für den Einsatz in explosionsgefährdeten Bereichen als besonders geeignet ist.

Diese Aufgabe wird durch eine Geräte-Anordnung gemäß dem unabhängigen Patentanspruch 1 gelöst. Bevorzugte Ausführungsformen sind Gegenstand der abhängigen Patentansprüche.

Grundgedanke der Erfindung ist demnach, das elektronische Gerät innen an einer im Gehäuse vorgesehenen Fensterscheibe ortsfest zu fixieren und die Fensterscheibe und, alternativ oder zusätzlich, das elektronische Gerät selbst, mittels einer Federungs-/Dämpfungseinrichtung am Gehäuse zu lagern. Unter dem Begriff "Federungs-/Dämpfungseinrichtung" zur Lagerung des inneren Gehäuses am äußeren Gehäuse seien im vorliegenden Zusammenhang jedwede Elemente gefasst, die federnde Eigenschaften und, alternativ oder zusätzlich, auch dämpfende Eigenschaften besitzen.

Für den Fall, dass die Fensterscheibe von außen einen Stoß oder Schlag erfährt, wird die dabei auf Fensterscheibe übertragene Energie wenigstens teilweise von der Federungs-/Dämpfungseinrichtung aufgenommen, wozu die Fensterscheibe einschließlich des an ihr befestigten elektronischen Geräts vorübergehend aus ihrer Ruhelage ausgelenkt wird. Auf diese Weise wird die stoß- bzw. schlagbedingte mechanische Belastung der Fensterscheibe in erheblichem Maße reduziert. Dies führt zu einer deutlichen verbesserten Bruchfestigkeit der Geräte-Anordnung im Zusammenhang mit auf die Fensterscheibe bzw. auf das Display wirkenden Stößen bzw. Schlägen, so dass das elektronische Gerät als Teil der hier vorgestellten, erfindungsgemäßen Geräte-Anordnung die zur Nutzung in explosionsgefährdeten Bereichen erforderlichen, gesetzlichen Mindestanforderungen erfüllt. Die hier vorgestellte Geräte-Anordnung eignet sich folglich für den Betrieb eines elektronischen Geräts in einem explosionsgefährdeten Bereich.

Eine erfindungsgemäße Geräte-Anordnung umfasst ein einen Gehäuseinnenraum umgebendes Gehäuse, welches ein Sichtfenster aufweist, das wiederum von einer durchsichtigen Fensterscheibe verschlossen wird. Im Gehäuseinnenraum angeordnet ist ein mit einem Display ausgestattetes elektronisches Gerät, insbesondere ein Tablet-Computer, das ortsfest an der Fensterscheibe befestigt ist. Die Geräte-Anordnung umfasst ferner die bereits erläuterte Federungs-/Dämpfungseinrichtung, mittels welcher sich die Fensterscheibe und/oder das elektronische Gerät am Gehäuse abstützen kann.

In einer bevorzugten Ausführungsform besitzt das Gehäuse eine das Sichtfenster einfassende Gehäusewand, gegen welche die Fensterscheibe und/oder das elektronische Gerät mittels der Federungs-/Dämpfungseinrichtung vorgespannt ist. Dies bedeutet, dass die Fensterscheibe bzw. das elektronische Gerät von innen gegen besagte Gehäusewand gedrückt wird und folglich mechanisch stabil an dieser anliegt, solange keine äußeren Stoßkräfte auf die Fensterscheibe einwirken. In einer Variante kann die Federungs-/Dämpfungseinrichtung allgemein gegen das Gehäuse vorgespannt sein.

Vorzugsweise ist die Fensterscheibe mittels der Federungs-/Dämpfungseinrichtung federnd am Gehäuse, insbesondere an der das Sichtfenster einfassenden Gehäusewand, gelagert. Auf diese Weise kann die Fensterscheibe sich im Falle eines Schlages oder Stoßes auf das Gehäuses temporär von diesem lösen, bevor sie mittels der Federungs-/Dämpfungseinrichtung erneut gegen das Gehäuse gedrückt wird. Auf diese Weise kann ein stoß- bzw. schlagbedingtes Bersten der Fensterscheibe verhindert werden.

Eine besonders gute Bruchfestigkeit der Fensterscheibe wird erzielt, wenn diese ohne Ausbildung einer stoffschlüssigen Verbindung und ohne Ausbildung einer Klebverbindung mit dem Gehäuse an dem Gehäuse, insbesondere an der Gehäusewand, anliegt.

Konstruktiv besonders einfach lässt sich die hier vorgestellte, erfindungswesentliche Federungs-/Dämpfungseinrichtung realisieren, indem wenigstens ein Federungs-/Dämpfungselement aus einem federelastischen Material vorgesehen wird. In aufwändigeren konstruktiven Ausgestaltungsvarianten können selbstverständlich auch mehrere solche Dämpfungs-/Federelemente vorgesehen werden, die lokal an verschiedenen, geeigneten Stellen im Gehäuse der Geräte-Anordnung angebracht werden können. Dem einschlägigen Fachmann eröffnet sich hier eine Vielzahl verschiedener, konstruktiver Ausgestaltungsformen, unter welche er unter anwendungsspezifischen Gesichtspunkten auszuwählen vermag.

Als aus fertigungstechnischer Sicht besonders vorteilhaft, weil kostengünstig herzustellen, mag indes eine Ausführungsform erachtet werden, bei welcher das wenigstens eine Federungs-/Dämpfungselement aus einem Elastomer, insbesondere aus einem Schaumstoff, hergestellt wird.

In einer weiteren bevorzugten Ausführungsform ist im Gehäuseinnenraum wenigstens ein erstes Federungs-/Dämpfungselement vorgesehen, mittels welchem sich die Fensterscheibe federelastisch am Gehäuse abstützen kann. Alternativ oder zusätzlich kann gemäß dieser Ausgestaltungsvariante im Gehäuse auch wenigstens ein zweites Federungs-/Dämpfungselement vorgesehen werden, mittels welchem sich auch das elektronische Gerät federelastisch am Gehäuse abstützen kann.

Die Bruchfestigkeit des Gehäuses der Geräte-Anordnung lässt sich in nicht unerheblichem Maße verbessern, indem am Gehäuse außen eine zusätzliche Federungs-/Dämpfungseinrichtung vorgesehen wird. Eine Solche mag etwa in Form einer Umhüllung mit federelastischen Eigenschaften realisiert sein, die im Bereich der Fensterscheibe eine Durchgangsöffnung besitzt, um einem Benutzer des elektronischen Geräts den Blick auf dessen Display freizugeben. Dem Fachmann eröffnet sich auch in diesem Szenario eine Vielzahl von Realisierungsmöglichkeiten; zu denken ist etwa daran, eine solche Umhüllung nur stegartig im Bereich der Gehäusekanten oder -ecken vorzusehen. In einer weiteren Variante kann die zusätzliche Federungs-/Dämpfungseinrichtung ein oder mehrere Federungs-/Dämpfungselemente aufweisen, das/die nur lokal an einer Gehäuseaußenseite des Gehäuses, beispielsweise auf einer von der Fensterscheibe abgewandten Rückscheibe des Gehäuses, befestigt sind.

Auch für die zusätzliche Federungs-/Dämpfungseinrichtung kann als Material ein Elastomer, beispielsweise ein Styrol-Blockcopolymer (SEBS) oder ein Ethylen-Propylen-Dien-Kautschuk (EPDM), in Betracht kommen.

Gemäß einer weiteren bevorzugten Ausführungsform wird vorgeschlagen, zwischen Gehäusewand und Fensterscheibe ein Dichtungselement vorzusehen, welches den Gehäuseinnenraum des Gehäuses gegen die Umgebung abdichtet. Auf diese Weise kann verhindert werden, dass ein etwaig in der Umgebung der Geräte-Anordnung vorhandenes explosives Gasgemisch in den Gehäuseinnenraum einzudringen vermag, wenn die beweglich gelagerte Fensterscheibe im Falle einer von außen wirkenden Stoßkraft aus seiner Ruhelage ausgelenkt wird, in der sie das Sichtfenster verschließt.

Besonders zweckmäßig kann das Dichtungselement in der Art eines Dichtungsrings ausgebildet sein, der das Sichtfenster umlaufend einfasst. Hierzu kann in der Gehäusewand optional eine zum Dichtungsring komplementär ausgebildete Dichtungsnut vorgesehen werden, in welcher der Dichtungsring wenigstens teilweise aufgenommen werden kann. Alternativ oder zusätzlich kann die Federungs-/Dämpfungseinrichtung das Sichtfenster wenigstens teilweise, vorzugsweise vollständig umlaufend, einfassen.

Eine besonders hohe Bruchfestigkeit der Geräte-Anordnung und somit ein besonders guter Schutz des im Gehäuse aufgenommenen elektronischen Geräts lässt sich indes erreichen, indem die Fensterscheibe zumindest teilweise, vorzugsweise vollständig, aus einem gehärteten Glas hergestellt ist.

Eine besonders stoßfeste Fixierung der das Sichtfenster verschließenden Fensterscheibe am Display des elektronischen Geräts lässt sich mit Hilfe einer durchsichtigen Klebeschicht erzielen, mittels welcher das elektronische Gerät mit seinem Display an der Fensterscheibe fixiert wird. Als Klebstoff mag dabei insbesondere ein Acrylat, insbesondere ein photoinitiiert härtendes Acrylat, herangezogen werden.

Eine besonders hohe Bruchfestigkeit des Gehäuses lässt sich erzielen, wenn als Material für das Gehäuse ein Metall gewählt wird. Verbesserte Dämpfungseigenschaften ergeben sich hingegen, wenn kein Metall, sondern ein Kunststoff, insbesondere ein Thermoplast wie beispielsweise Polyamid, verwendet wird.

Weitere wichtige Merkmale und Vorteile der Erfindung ergeben sich aus den Unteransprüchen, aus der Zeichnung und aus der zugehörigen Figurenbeschreibung anhand der Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in der Zeichnung dargestellt und werden in der nachfolgenden Beschreibung näher erläutert.

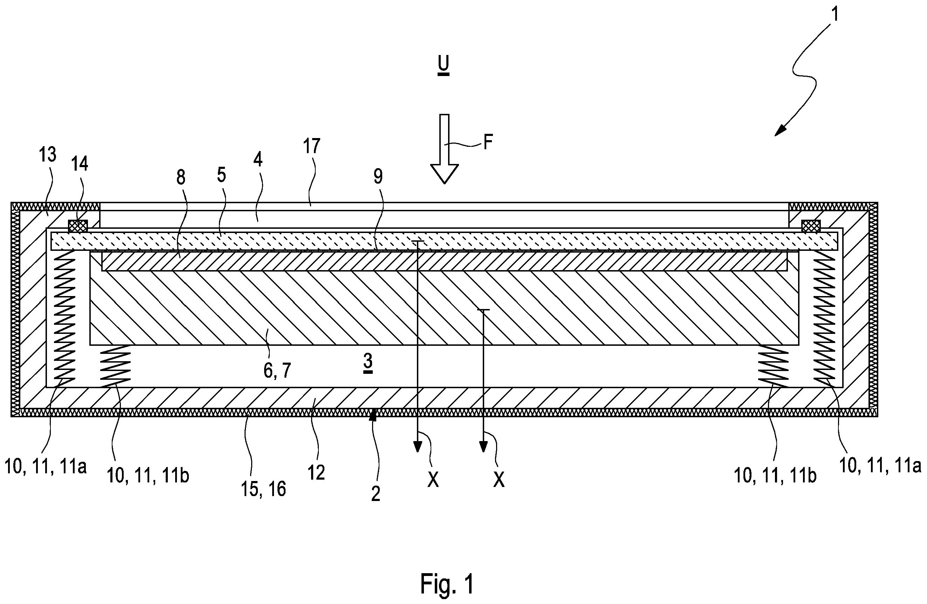

Die einzige Figur 1 zeigt in grobschematischer Darstellung und in einem Längsschnitt ein Beispiel einer erfindungsgemäßen Geräte-Anordnung 1. Die Anordnung 1 umfasst ein Gehäuse 2 aus einem Metall welches einen Gehäuseinnenraum 3 umgibt. In einer Variante kann das Gehäuse 2 auch aus einem, vorzugsweise thermoplastischen, Kunststoff gefertigt sein. Im Gehäuse 2 ist ein Sichtfenster 4 vorgesehen, das wiederum von einer durchsichtigen Fensterscheibe 5 aus gehärtetem Glas verschlossen wird. Im Gehäuseinnenraum 3 ist ein elektronisches Gerät 6 in Form eines Tablet-Computers 7 mit einem berührungsempfindlichen Display 8 angeordnet. Das berührungsempfindliche Display 8 und somit das gesamte elektronische Gerät 6 wird mit Hilfe einer durchsichtigen Klebeschicht 9 ortsfest an der Fensterscheibe 5 fixiert. Als Klebstoff wird ein Acrylat, insbesondere ein photoinitiiert härtendes Acrylat, verwendet.

Die Geräte-Anordnung 1 umfasst ferner eine Federungs-/Dämpfungseinrichtung 10, mittels welcher sich die Fensterscheibe 5 und auch das elektronische Gerät 6 am Gehäuse 2 abstützen können. Im Falle eines von außen auf die Fensterscheibe 5 wirkenden mechanischen Stoßes - in Figur 1 schematisch durch einen mit F bezeichneten Pfeil angedeutet - wird die beim Stoß übertragenen Energie wenigstens teilweise von der Federungs-/Dämpfungseinrichtung 10 aufgenommen, wobei die Fensterscheibe 5 einschließlich des an ihr befestigten elektronischen Geräts 6 vorübergehend aus ihrer Ruhelage ausgelenkt wird. Auf diese Weise wird die stoßbedingte mechanische Belastung der Fensterscheibe 5 in erheblichem Maße reduziert. Dies führt zu einer verbesserten Bruchfestigkeit der gesamten Geräte-Anordnung 1 im Zusammenhang mit auf die Fensterscheibe 5 bzw. auf das Display 8 wirkenden mechanischen Stößen bzw. Schlägen. Die Auslenkung der Fensterscheibe 5 bzw. des elektronischen Geräts 6 aus der Ruhelage wird im Beispiel der Figur 1 durch die Pfeile X wiedergegeben.

Vorzugsweise ist die Fensterscheibe 5 mittels der Federungs-/Dämpfungseinrichtung 10 federnd am Gehäuse 2, insbesondere an der das Sichtfenster 4 einfassenden Gehäusewand 13, gelagert. Auf diese Weise kann die Fensterscheibe 5 sich im Falle eines Schlages oder Stoßes auf das Gehäuse 2 temporär von diesem lösen, bevor es mittels der Federungs-/Dämpfungseinrichtung 10 erneut gegen das Gehäuse 2 gedrückt wird. Somit kann ein stoß- bzw. schlagbedingtes Bersten der Fensterscheibe 5 besonders wirksam verhindert werden. Eine besonders hohe Bruchfestigkeit der Fensterscheibe 5 wird dabei erzielt, wenn diese ohne Ausbildung einer stoffschlüssigen Verbindung und ohne Ausbildung einer Klebverbindung mit dem Gehäuse 2 am Gehäuse 2, insbesondere an der Gehäusewand 13, anliegt. Besonders bevorzugt kann die Federungs-/Dämpfungseinrichtung 10 gegen das Gehäuse 2, insbesondere gegen die Gehäusewand 13, vorgespannt sein.

Wie Figur 1 erkennen lässt, umfasst die Federungs-/Dämpfungseinrichtung 10 mehrere Federungs-/Dämpfungselemente 11 aus einem federelastischen Material. Als Material mag beispielsweise ein Elastomer, insbesondere ein Schaumstoff, herangezogen werden. Im Gehäuseinnenraum 3 des Beispielszenarios sind vier erste Federungs-/Dämpfungselemente 11a angeordnet, von welchen im Längsschnitt der Figur 1 lediglich zwei Elemente 11a dargestellt sind. Die Federungs-/Dämpfungselemente 11a können bezüglich einer Draufsicht von innen auf die Fensterscheibe 5 im Bereich ihrer vier Ecken angeordnet sein (nicht gezeigt). Mittels der ersten Federungs-/Dämpfungselemente 11a stützt sich die Fensterscheibe 5 federelastisch am Gehäuse 2 ab.

Im Gehäuseinnenraum 3 sind darüber hinaus zusätzlich auch vier zweite Federungs-/Dämpfungselemente 11b angeordnet, von welchen in Figur 1 ebenfalls nur zwei gezeigt sind. Mittels der zweiten Federungs-/Dämpfungselemente 11a stützt sich das elektronische Gerät 6 federelastisch am Gehäuse 2 ab. Die Federungs-/Dämpfungselemente 11a können bezüglich einer Draufsicht von innen auf einen dem Sichtfenster 4 gegenüberliegenden Gehäuseboden 12 im Bereich dessen vier Ecken angeordnet sein (nicht gezeigt). In konstruktiv vereinfachten Varianten des Beispiels können auch ausschließlich erste Federungs-/Dämpfungselemente 11a oder ausschließlich zweite Federungs-/Dämpfungselemente 11b vorgesehen sein.

Das Gehäuse 2 besitzt ferner eine das Sichtfenster 4 einfassende Gehäusewand 13, gegen welche die Fensterscheibe 5 mit Hilfe der ersten und zweiten Federungs-/Dämpfungselemente 11a, 11b der Federungs-/Dämpfungseinrichtung 10 von innen gedrückt wird, so dass sie mechanisch stabil an der Gehäusewand 13 anliegt, solange keine äußeren Stoßkräfte F auf die Fensterscheibe 5 einwirken. In einer in Figur 1 nicht dargestellten Variante können sich erste Federungs-/Dämpfungselemente 11a auch an der Gehäusewand 13 abstützen.

Der Figur 1 lässt sich ferner entnehmen, dass zwischen der Gehäusewand 13 und der Fensterscheibe 5 ein Dichtungselement 14 in Form eines Dichtungsrings vorgesehen ist, welches den Gehäuseinnenraum 3 des Gehäuses 2 gegen die Umgebung U der Geräte-Anordnung 1 abdichtet. Hierzu wird das Dichtungselement 14 teilweise in einer innen an der Gehäusewand 13 vorgesehenen Aufnahmenut aufgenommen, welche das Sichtfenster 4 vollständig umlaufend einfasst. Alternativ oder zusätzlich kann auch die Federungs-/Dämpfungseinrichtung das Sichtfenster wenigstens teilweise, vorzugsweise vollständig umlaufend, einfassen. Auf diese Weise wird vermieden, dass ein etwaig in der Umgebung U vorhandenes explosives Gasgemisch in den Gehäuseinnenraum 3 eindringen kann. Das Dichtungselement 14 ist dabei derart dimensioniert, dass besagte Dichtungswirkung auch dann erhalten bleibt, wenn die beweglich gelagerte Fensterscheibe 5 aufgrund der von außen wirkenden Stoßkraft F aus ihrer Ruhelage ausgelenkt wird.

Weiterhin kann am Gehäuse 2 außen eine zusätzliche Federungs-/Dämpfungseinrichtung 15 vorgesehen sein, die in Figur 1 nur schematisch dargestellt ist. Eine solche zusätzliche Federungs-/Dämpfungseinrichtung 15 mag etwa in Form einer Umhüllung 16 mit federelastischen Eigenschaften realisiert sein, die im Bereich der Fensterscheibe 5 eine Durchgangsöffnung 17 aufweist, um den Benutzer des elektronischen Geräts 6 den Blick auf das Display 8 nicht zu versperren. Dem Fachmann eröffnet sich hinsichtlich der Realisierung der Federungs-/Dämpfungseinrichtung eine Vielzahl von Optionen; zu denken ist etwa daran, eine solche Umhüllung nur stegartig im Bereich der Gehäusekanten oder -ecken vorzusehen.

In einer weiteren, in Figur 1 nicht gezeigten Variante kann die zusätzliche Federungs-/Dämpfungseinrichtung 15 etwa ein oder mehrere Federungs-/Dämpfungselemente aufweisen, das/die nur lokal an einer Gehäuseaußenseite des Gehäuses 2, beispielsweise auf einer von der Fensterscheibe abgewandten Rückscheibe des Gehäuses 2, befestigt ist/sind.

Als Material für die zusätzliche Federungs-/Dämpfungseinrichtung 15 kommt ein Elastomer, beispielsweise das genannte Styrol-Blockcopolymer (SEBS) oder ein Ethylen-Propylen-Dien-Kautschuk (EPDM) in Betracht. Auch die Verwendung eines Schaumstoffs ist vorstellbar.

## Patentansprüche

1. Geräte-Anordnung (1),
- mit einem einen Gehäuseinnenraum (3) umgebenden Gehäuse (2), welches ein Sichtfenster (4) aufweist, das von einer durchsichtigen Fensterscheibe (5) verschlossen ist,
- mit einem im Gehäuseinnenraum (3) angeordneten und ein Display (8) aufweisenden elektronischen Gerät (6),
- mit einer Federungs-/Dämpfungseinrichtung (10), mittels welcher sich die Fensterscheibe (5) am Gehäuse (2) abstützt,
**dadurch gekennzeichnet, dass**
- das elektronische Gerät (6) ortsfest an der Fensterscheibe (5) befestigt ist,
- die Fensterscheibe (5) mittels einer Klebeschicht, (9) die einen durchsichtigen Klebstoff umfasst, am Display (8) des elektronischen Geräts (6) befestigt ist,
- die Fensterscheibe (5) aus einem gehärteten Glas oder einer durchsichtigen Keramik oder einer Kombination aus beidem hergestellt ist.

2. Geräte-Anordnung nach Anspruch 1, **dadurch gekennzeichnet, dass**
- das Gehäuse (2) eine das Sichtfenster (4) einfassende Gehäusewand (13) aufweist,
- die Fensterscheibe (5) und das elektronische Gerät (6) mittels der Federungs-/Dämpfungseinrichtung (10) gegen das Gehäuse (2) vorgespannt sind.

3. Geräte-Anordnung nach Anspruch 1 oder 2,
**dadurch gekennzeichnet, dass**
die Federungs-/Dämpfungseinrichtung (10) wenigstens ein Federungs-/Dämpfungselement (11, 11a, 11b) aus einem federelastischen Material umfasst.

4. Geräte-Anordnung nach einem der Ansprüche 1 bis 3,
**dadurch gekennzeichnet, dass**
die Fensterscheibe (5) mittels der Federungs-/Dämpfungseinrichtung (10) federnd am Gehäuse (2) gelagert ist.

5. Geräte-Anordnung nach einem der vorhergehenden Ansprüche,
**dadurch gekennzeichnet, dass** die Federungs-/Dämpfungseinrichtung (10) wenigstens ein erstes Federungs-/Dämpfungselement (11a) umfasst, mittels welchem sich die Fensterscheibe (5) am Gehäuse (2) federelastisch abstützt, und dass die Federungs-/ Dämpfungseinrichtung (10) wenigstens ein zweites Federungs-/Dämpfungselement (11b) umfasst, mittels welchem sich das elektronische Gerät (6) federelastisch am Gehäuse (2) abstützt.

6. Geräte-Anordnung nach einem der vorhergehenden Ansprüche,
**dadurch gekennzeichnet, dass**
am Gehäuse (2) außen eine zusätzliche Federungs-/Dämpfungseinrichtung (15) vorgesehen ist.

7. Geräte-Anordnung nach einem der Ansprüche 2 bis 6,
**dadurch gekennzeichnet, dass**
zwischen der Gehäusewand (13) und der Fensterscheibe (5) ein Dichtungselement (14) vorgesehen ist, welches den Gehäuseinnenraum (3) des Gehäuses (2) gegen die Umgebung (U) der Geräte-Anordnung (1) abdichtet.

8. Geräte-Anordnung nach Anspruch 7,
**dadurch gekennzeichnet, dass**
das Dichtungselement (14) das Sichtfenster (4) umlaufend einfasst, und/oder dass
die Federungs-/Dämpfungseinrichtung (10) das Sichtfenster (4) wenigstens teilweise einfasst.

9. Geräte-Anordnung nach einem der vorhergehenden Ansprüche,
**dadurch gekennzeichnet, dass**
das Gehäuse (2) aus einem Metall oder aus einem Kunststoff hergestellt ist.

## Claims

1. Device arrangement (1),
- with a housing (2) surrounding a housing interior (3), which housing has a viewing window (4) which is sealed by a transparent window pane (5),
- with an electronic device (6) arranged in the housing interior (3) and having a display (8),
- with a suspension/damping device (10) by means of which the window pane (5) is supported on the housing (2),
**characterised in that**
- the electronic device (6) is secured immovably onto the window pane (5),
- the window pane (5) is secured by means of an adhesive layer (9), which comprises a transparent adhesive, onto the display (8) of the electronic device (6),
- the window pane (5) is made from a hardened glass or a transparent ceramic or a combination of the two.

2. Device arrangement according to claim 1,
**characterised in that**
- the housing (2) has a housing wall (13) bordering the viewing window (4),
- the window pane (5) and the electronic device (6) are pretensioned against the housing (2) by means of the suspension/damping device (10).

3. Device arrangement according to claim 1 or 2,
**characterised in that**
the suspension/damping device (10) comprises at least one suspension/damping element (11, 11a, 11b) made of a resilient material.

4. Device arrangement according to any of claims 1 to 3,
**characterised in that**
the window pane (5) is mounted flexibly on the housing (2) by means of the suspension/damping device (10).

5. Device arrangement according to any of the preceding claims,
**characterised in that** the suspension/damping device (10) comprises at least one first suspension/damping element (11a), by means of which the window pane (5) is supported resiliently on the housing (2), and **in that** the suspension/damping device (10) comprises at least one second suspension/damping element (11b), by means of which the electronic device (6) is supported resiliently on the housing (2).

6. Device arrangement according to any of the preceding claims,
**characterised in that**
on the exterior of the housing (2) an additional suspension/damping device (15) is provided.

7. Device arrangement according to any of claims 2 to 6,
**characterised in that**
a sealing element (14) is provided between the housing wall (13) and the window pane (5), which sealing element seals the housing interior (3) of the housing (2) from the surrounding area (U) of the device arrangement (1).

8. Device arrangement according to claim 7,
**characterised in that**
the sealing element (14) circumferentially borders the viewing window (4) and/or **in that**
the suspension/damping device (10) at least partially borders the viewing window (4).

9. Device arrangement according to any of the preceding claims,
**characterised in that**
the housing (2) is made of metal or of plastic.

## Revendications

1. Agencement d'appareil (1),
- avec un corps (2), qui entoure un intérieur de corps (3) et qui présente une fenêtre de vue (4) qui est fermée par une vitre de fenêtre (5) transparente,
- avec un appareil électronique (6) agencé dans l'intérieur de corps (3) et présentant un écran d'affichage (8),
- avec un dispositif de suspension élastique / d'amortissement (10), au moyen duquel la vitre de fenêtre (5) s'appuie contre le corps (2),
**caractérisé en ce que**
- l'appareil électronique (6) est fixé à la vitre de fenêtre (5) sans pouvoir bouger,
- la vitre de fenêtre (5) est fixée à l'écran d'affichage (8) de l'appareil électronique (6) au moyen d'une couche adhésive (9) qui comprend un adhésif transparent,
- la vitre de fenêtre (5) est fabriquée en verre trempé ou en céramique transparente ou en une combinaison des deux.

2. Agencement d'appareil selon la revendication 1,
**caractérisé en ce que**
- le corps (2) présente une paroi de corps (13) entourant la fenêtre de vue (4),
- la vitre de fenêtre (5) et l'appareil électronique (6) sont poussés contre le corps (2) au moyen du dispositif de suspension élastique / d'amortissement (10).

3. Agencement d'appareil selon la revendication 1 ou 2,
**caractérisé en ce que**
le dispositif de suspension élastique / d'amortissement (10) comprend au moins un élément de suspension élastique / d'amortissement (11, 11a, 11b) en un matériau élastique.

4. Agencement d'appareil selon l'une quelconque des revendications 1 à 3,
**caractérisé en ce que**
la vitre de fenêtre (5) est montée sur le corps (2) de manière élastique au moyen du dispositif de suspension élastique / d'amortissement (10).

5. Agencement d'appareil selon l'une quelconque des revendications précédentes,
**caractérisé en ce que** le dispositif de suspension élastique / d'amortissement (10) comprend au moins un premier élément de suspension élastique / d'amortissement (11a) au moyen duquel la vitre de fenêtre (5) s'appuie élastiquement contre le corps (2) et **en ce que** le dispositif de suspension élastique / d'amortissement (10) comprend au moins un deuxième élément de suspension élastique / d'amortissement (11b) au moyen duquel l'appareil électronique (6) s'appuie élastiquement contre le corps (2).

6. Agencement d'appareil selon l'une quelconque des revendications précédentes,
**caractérisé en ce**
**qu'**il est prévu au niveau du corps (2), à l'extérieur, un dispositif de suspension élastique / d'amortissement (15) supplémentaire.

7. Agencement d'appareil selon l'une quelconque des revendications 2 à 6,
**caractérisé en ce**
**qu'**il est prévu entre la paroi de corps (13) et la vitre de fenêtre (5) un élément d'étanchéité (14) qui étanchéifie l'intérieur de corps (3) du corps (2) vis-à-vis de l'environnement (U) de l'agencement d'appareil (1).

8. Agencement d'appareil selon la revendication 7,
**caractérisé en ce que**
l'élément d'étanchéité (14) entoure par sa périphérie la fenêtre de vue (4) et/ou **en ce que**
le dispositif de suspension élastique / d'amortissement (10) entoure au moins partiellement la fenêtre de vue (4).

9. Agencement d'appareil selon l'une quelconque des revendications précédentes,
**caractérisé en ce que**
le corps (2) est fabriqué en métal ou en plastique.
